# EUROPÄISCHE PATENTSCHRIFT

(11) **EP 0 735 493 B1**
(45) Veröffentlichungstag und Bekanntmachung des Hinweises auf die Patenterteilung: **24.11.2004**
(21) Anmeldenummer: 95104708.3
(22) Anmeldetag: 30.03.1995
(51) Int. Cl.: G06F 13/40, H03K 19/003, H03K 17/08

(54) **Bus-Treiberschaltung**
Bus driver circuit
Circuit d'attaque de bus

(43) Veröffentlichungstag der Anmeldung: 02.10.1996
(73) Patentinhaber: TEXAS INSTRUMENTS DEUTSCHLAND GMBH, 85356 Freising (DE)
(72) Erfinder: Scoones, Kevin, D-85368 Moosburg (DE)
(74) Vertreter: Degwert, Hartmut, Dipl.-Phys.

(56) Entgegenhaltungen:
- EP-A- 0 366 083
- EP-A- 0 545 361
- US-A- 5 019 720

## Beschreibung

Die Erfindung bezieht sich auf eine Bus-Treiberschaltung, wie sie im Oberbegriff des Patentanspruchs 1 definiert ist.

Bus-Treiberschaltungen werden dazu verwendet, an einen Datenübertragungsbus Datensignale anzulegen, die über den Bus zu Datenempfängern übertragen werden sollen. Der Bus bildet dabei in der Regel einen Teil eines Systems aus Datensendern und Datenempfängern, wobei die Datensender beispielsweise Sensoren sein können, während die Datenempfänger beispielsweise von Steuerorganen oder auch von Anzeigevorrichtungen gebildet sein können.

Üblicherweise werden die Informationen über den Bus in Form digitaler Signale übertragen, wobei das Vorhandensein des Signals mit dem Signalwert 1 dann erkannt wird, wenn beispielsweise eine positive Spannung von 5V an den Bus angelegt wird. Die Bus-Treiberschaltung hat die Aufgabe, diese Spannung von +5V an der Ader des Busses zu erzeugen. Da an die Ader des Busses in der Regel eine größere Anzahl von Bus-Treiberschaltungen angeschlossen ist, kann es aufgrund von Störungen vorkommen, daß am Bus auch eine höhere Spannung als +5V auftritt. In diesem Fall muß dafür gesorgt werden, daß diese höhere Spannung nicht zu einer übermäßig starken Belastung der die Spannung von +5V liefernden Quelle führt. Die höhere Spannung könnte auch zur Folge haben, daß die Spannung an der Bus-Ader auf einen bestimmten Pegel geklemmt wird und nicht mehr verändert werden kann.

Der Erfindung liegt die Aufgabe zugrunde, eine Bus-Treiberschaltung zu schaffen, bei der die oben geschilderten Probleme nicht mehr auftreten und die sich mit Bauelementen als integrierte Schaltung herstellen läßt, die auf der Oberfläche des Halbleiter-Plättchens nur eine geringe Fläche benötigen.

Diese Aufgabe wird gemäß der Erfindung mit den im kennzeichnenden Teil des Patentanspruchs 1 angegebenen Merkmalen gelöst.

Ein Ausführungsbeispiel der Erfindung wird nun anhand der Zeichnungen erläutert. Es zeigen:
Figur 1 eine schematische Darstellung zur Erläuterung der Verwendung der erfindungsgemäßen Bus-Treiberschaltung beim Ansteuern eines Busses und
Figur 2 ein Schaltbild der erfindungsgemäßen Bus-Treiberschaltung.

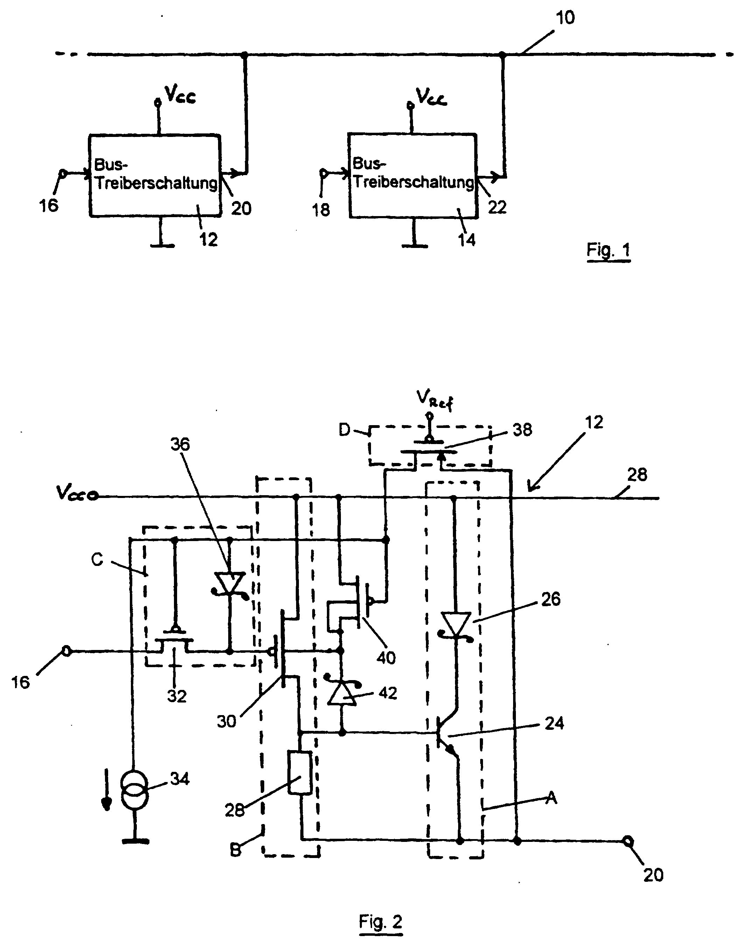

In Figur 1 ist ein Abschnitt einer Bus-Ader 10 dargestellt, an die zwei Treiberschaltungen 12, 14 angeschlossen sind. Es sei bemerkt, daß in der Regel an eine Bus-Ader natürlich mehrere Treiberschaltungen angeschlossen sein können. Jede Bus-Treiberschaltung 10, 12 weist einen Treibereingang 16 bzw. 18 auf, an den ein an den Bus anzulegendes Datensignal angelegt werden kann. Die Datensignale können beispielsweise von Sensoren oder anderen signalerzeugenden Baueinheiten kommen. Das Anlegen der Datensignale an den Bus erfolgt über die Busausgänge 20, 22.

Die Bus-Treiberschaltungen 12, 14 werden mittels einer Spannungsquelle gespeist, die die Spannung Vcc liefert, die in der Praxis +5V beträgt. Das Anlegen der Datensignale an die Bus-Ader 10 erfolgt dadurch, daß die Spannung Vcc an die Bus-Ader 10 angelegt wird.

Figur 2 zeigt den Aufbau der Bus-Treiberschaltung 12. Die Bus-Treiberschaltung 14 ist natürlich ebenso aufgebaut.

Zum Durchschalten der Spannung Vcc an den Ausgang 20 enthält die Bus-Treiberschaltung 12 einen bipolaren NPN-Transistor 24, dessen Kollektor-Emitter-Strecke über eine Schottky-Diode 26 in Serie zwischen der Vcc-Leitung 28 und dem Ausgang 20 liegt. Die Schottky-Diode 26 und der NPN-Transistor 24 bilden einen ersten steuerbaren Schalter A.

Die Basis des NPN-Transistors 24 ist mit dem Verbindungspunkt zwischen einem Widerstand 28 und dem Source-Anschluß eines PMOS-Transistors 30 verbunden, dessen Drain-Anschluß mit der Vcc-Leitung 28 verbunden ist. Das andere Ende des Widerstandes 28 ist mit dem Ausgang 20 verbunden. Der PMOS-Transistor 30 und der Widerstand 28 bilden zusammen einen Steuerschaltungszweig B, mit dessen Hilfe der steuerbare Schalter 24, 26 gesteuert werden kann.

Der Gate-Anschluß des PMOS-Transistors 30 ist über die Source-Drain-Strecke eines weiteren PMOS-Transistors 32 mit dem Treibereingang 16 verbunden. Der Gate-Anschluß dieses PMOS-Transistors 32 steht über eine Stromquelle 24 mit Masse in Verbindung, und andererseits ist er über ein Schottky-Diode 36 mit seinem Drain-Anschluß verbunden. Der PMOS-Transistor 32 und die Schottky-Diode 36 bilden einen weiteren steuerbaren Schalter C.

Ein Komparator D, der von einem weiteren PMOS-Transistor gebildet wird, liegt mit seiner Source-Drain-Strecke zwischen dem Treiberausgang 20 und dem Gate-Anschluß des PMOS-Transistors 32. Am Gate-Anschluß dieses PMOS-Transistors 38 liegt eine Referenzspannung V_{Ref}, deren Zweck noch erläutert wird.

Zwischen der Vcc-Leitung 28 und dem Basis-Anschluß des NPN-Transistors 24 liegt eine Serienschaltung aus der Source-Drain-Strecke eines PMOS-Transistors 40 und einer Schottky-Diode 42. Der Gate-Anschluß dieses PMOS-Transistors 40 ist mit dem Drain-Anschluß des PMOS-Transistors 38 und mit dem Gate-Anschluß des PMOS-Transistors 32 verbunden. Der Verbindungspunkt zwischen dem Source-Anschluß des PMOS-Transistors 40 und der Katode der Schottky-Diode 42 ist mit der Substratwanne des PMOS-Transistors 30 verbunden. Die Funktion des PMOS-Transistors 40 und der Schottky-Diode 42 werden anschließend noch erläutert. Die Arbeitsweise der Bus-Treiberschaltung von Figur 2 wird nun näher erläutert.

Zunächst wird der Zustand betrachtet, bei dem kein Datensignal an die Bus-Ader 10 angelegt werden soll. Dies bedeutet, daß am Treiberausgang 20 ein niedriger Signalwert vorhanden ist, während am Treibereingang 16 eine Spannung von +5V vorhanden ist. Diese Spannung hat zur Folge, daß der PMOS-Transistor 30 gesperrt ist, so daß über seine Source-Drain-Strecke und damit durch den Widerstand 28 kein Strom fließt. Somit liegt auch die Basis des NPN-Transistors 24 an einer niedrigen Spannung, die diesen Transistor in gesperrtem Zustand hält. Die Stromquelle 34, über die stets ein kleiner Strom von ca. 10 bis 50 µA fließt, hält den Gate-Anschluß des PMOS-Transistors 32 auf Masse, so daß sich dieser Transistor im leitenden Zustand befindet. Die Diode 36 ist unter diesen Umständen in Sperrichtung vorgespannt, so daß sie keine Wirkung hat. Der PMOS-Transistor 38 ist gesperrt, weil die Spannung an seinem Source-Anschluß, der mit dem Treiberausgang 20 verbunden ist, niedriger als die Spannung an seinem Gate-Anschluß ist, die einen Wert in der Größenordnung von +4V hat.

Wenn nun an den Treibereingang 16 ein Datensignal angelegt wird, das definitionsgemäß ein Signal mit einem niedrigen Spannungswert ist, bewirkt dieses Signal, daß der PMOS-Transistor 30 in den leitenden Zustand übergeht. Dadurch fließt durch den Widerstand 28 ein Strom, der einen Spannungsabfall an der Basis des NPN-Transistors 24 erzeugt. Dieser NPN-Transistor 24 geht daher in den leitenden Zustand über, so daß die Spannung an der Vcc-Leitung 28 zum Treiberausgang 20 durchgeschaltet wird. An der Schottky-Diode 26 und am NPN-Transistor 24 tritt nur ein kleiner Spannungsabfall auf, so daß der Spannungswert am Treiberausgang 20 nahe bei der Spannung Vcc von +5V liegt, in der Praxis bei +4V. Diese Durchschalten der Spannung Vcc zur Bus-Ader 10 kann von einem mit der Bus-Ader verbundenen Empfänger erfaßt werden, der daraufhin die Verarbeitung des Datensignals durchführen kann.

Wenn nun angenommen wird, daß im Bus-System ein Fehler auftritt, der zur Folge hat, daß an der Bus-Ader 10 eine Spannung auftritt, die höher als +5V ist, dann müssen Vorkehrungen getroffen werden, um zu verhindern, daß die diese Spannung liefernde Quelle über die gerade aktive Bus-Treiberschaltung nicht übermäßig belastet wird. Fehler dieser Art können beispielsweise durch kapazitive Einstreuungen hervorgerufen werden.

Sobald an der Bus-Ader 10 eine über +5V liegende Spannung auftritt, gelangt diese Spannung über den Treiberausgang 20 an den Source-Anschluß PMOS-Transistors 38. Da die Spannung V_{Ref} an seinem Gate-Anschluß kleiner als +5V ist, schaltet dieser PMOS-Transistor durch, so daß die hohe Spannung auch an die Anode der Schottky-Diode 36 und den Gate-Anschluß des PMOS-Transistors 32 gelangt. Über die Schottky-Diode 36 gelangt die hohe Spannung an den Gate-Anschluß des PMOS-Transistors 30, der dadurch gesperrt wird. Auch der PMOS-Transistor 32 geht in den gesperrten Zustand über. Das Sperren des PMOS-Transistors 30 hat zur Folge, daß am Widerstand 28 kein Spannungsabfall mehr auftritt, so daß folglich auch der NPN-Transistor 24 gesperrt wird. Die die Spannung Vcc liefernde Quelle wird daher nicht mehr belastet, da durch den NPN-Transistor 24 kein Strom mehr fließen kann. Das Sperren des PMOS-Transistors 32 bewirkt eine Entkoppelung des Treibereingangs 16 vom Gate-Anschluß des PMOS-Transistors 30.

Wie zu erkennen ist, wirkt der PMOS-Transistor 38 als Komparator D, der die Spannung am Treiberausgang 20 und somit an der Bus-Ader 10 mit der Spannung V_{Ref} vergleicht und ein Steuersignal an die von der Schottky-Diode 36 und dem PMOS-Transistor 32 gebildete Schaltvorrichtung liefert, damit diese den PMOS-Transistor 30 in den gesperrten Zustand versetzen kann, wenn die Spannung an der Bus-Ader 10 größer als die zulässige Spannung vom +5V wird.

Die Funktion der beschriebenen Treiberschaltung, eine Belastung der die Spannung Vcc liefernden Quelle zu verhindern, wenn am Bus eine Spannung von mehr als Vcc auftritt, ist immer wirksam, also auch dann, wenn die Treiberschaltung inaktiv ist und am Treibereingang kein Datensignal empfängt.

Bei Herstellung der Bus-Treiberschaltung als integrierte Schaltung können die Bauelemente, die das Abtrennen der Quelle der Spannung Vcc vom Treiberausgang 20 bewirken, auf einer kleinen Fläche des die integrierte Schaltung enthaltenden Substrats hergestellt werden, weil sie lediglich als Schalter wirksam werden und nicht durch einen hohen Widerstand den unerwünschten Strom aus der Quelle der Spannung Vcc reduzieren müssen. Der PMOS-Transistor 40 und die Schottky-Diode 42 werden benötigt, um die unerwünschten Einflüsse der in der integrierten Schaltung vorhandenen Dioden zwischen dem Source-Anschluß, dem Drain-Anschluß und der Wanne, in der der PMOS-Transistor 30 gebildet ist, zu beseitigen. Diese unerwünschten Wirkungen werden in der englischsprachigen Literatur als Back-Gate-Wirkungen bezeichnet; die zu ihrer Beseitigung eingesetzten Mittel sind herkömmlicher Art.

## Patentansprüche

1. Bus-Treiberschaltung mit einem Treibereingang (16) für den Empfang eines Datensignals und einem Treiberausgang (20) zum Anlegen der Ausgangsspannung einer Spannungsquelle (Vcc) an eine Bus-Ader (10) in Abhängigkeit vom Vorhandensein des Datensignals am Treibereingang (16), **gekennzeichnet durch**
a) einen zwischen der Spannungsquelle (Vcc) und dem Treiberausgang (20) liegenden ersten steuerbaren Schalter (A),
b) einen Steuerschaltungszweig (B), der beim Anlegen des Datensignals an den Treibereingang (16) in einen aktiven Zustand versetzbar ist, indem er ein Ansteuersignal erzeugt, das den steuerbaren Schalter (A) in den leitenden Zustand versetzt,
c) einen zweiten steuerbaren Schalter (C) zwischen dem Steuerschaltungszweig (B) und dem Treibereingang (16) und
d) einen Komparator (D), der die Spannung am Treiberausgang (20) mit einer Referenzspannung (V_{Ref}) vergleicht und dann, wenn die Spannung am Treiberausgang (20) größer als die Ausgangsspannung (Vcc) der Spannungsquelle ist, ein Steuersignal abgibt, das den zweiten steuerbaren Schalter (C) sperrt und den Steuerschaltungszweig (B) in den inaktiven Zustand versetzt, indem er den ersten steuerbaren Schalter (A) sperrt.

2. Bus-Treiberschaltung nach Anspruch 1, **dadurch gekennzeichnet, daß** der Steuerschaltungszweig (B) in Serie zwischen der Spannungsquelle und dem Treiberausgang (20) einen PMOS-Transistor (30) und einen Widerstand (28) enthält, daß der Gate-Anschluß des PMOS-Transistors (30) im Steuerschaltungszweig (B) über die Source-Drain-Strecke eines weiteren PMOS-Transistors (32) mit dem Treibereingang (16) verbunden ist, der dem zweiten steuerbaren Schalter (C) angehört, und daß der Verbindungspunkt zwischen dem Source-Anschluß des PMOS-Transistors (30) und dem Widerstand (28) mit einem Steueranschluß des ersten steuerbaren Schalters (A) verbunden ist.

3. Bus-Treiberschaltung nach Anspruch 2, **dadurch gekennzeichnet, daß** der erste steuerbare Schalter (A) in Serie zwischen der Spannungsquelle (Vcc) und dem Treiberausgang (20) eine Schottky-Diode (26) und die Kollektor-Emitter-Strecke eines NPN-Transistors enthält, wobei der Steueranschluß des ersten steuerbaren Schalters (A) die Basis des NPN-Transistors 24 ist.

4. Bus-Treiberschaltung nach Anspruch 2 oder 3, **dadurch gekennzeichnet, daß** der zweite steuerbare Schalter (C) einen vom Komparator (D) gesteuerten PMOS-Transistor (32) enthält, dessen Source-Drain-Strecke in Serie zwischen dem Treibereingang (16) und dem Gate-Anschluß des PMOS-Transistors (30) liegt, und daß er ferner eine Schottky-Diode (36) enthält, die die Spannung vom Treiberausgang (20) zum Gate-Anschluß des PMOS-Transistors (30) durchschaltet, wenn der Komparator (D) das Steuersignal abgibt.

## Claims

1. A bus driver circuit comprising a driver input (16) for receiving a data signal and a driver output (20) for applying the output voltage of a voltage source (Vcc) to a bus line (10) as a function of the presence of the data signal at the driver input (16), **characterized by**
(a) a first controllable switch (A) connected between the voltage source (Vcc) and the driver output (20),
(b) a control circuit branch (B), which upon application of the data signal to the driver input (16) can be placed in an active state by it producing a drive signal placing the controllable switch (A) in the conducting state,
(c) a second controllable switch (C) between the control circuit branch (B) and the driver input (16), and
(d) a comparator (D) which compares the voltage at the driver output (20) with a reference voltage (V_{ref}) and, when the voltage at the driver output (20) exceeds the output voltage (Vcc) of the voltage source, supplies a control signal turning off the second controllable switch (C) and placing the control circuit branch (B) in the inactive state by turning off the first controllable switch (A).

2. The bus driver circuit as claimed in claim 1, **characterized in that** the control circuit branch (B) includes a PMOS transistor (30) and a resistor (28) in series between the voltage source and the driver output (20), that the gate of the PMOS transistor (30) in the control circuit branch (B) is connected via the source-drain path of a further PMOS transistor (32) with the driver input (16) which is associated with the second controllable switch (C), and that the node between the source of the PMOS transistor (30) and the resistor (28) is connected with a gate terminal of the first controllable switch (A).

3. The bus driver circuit as claimed in claim 2, **characterized in that** the first controllable switch (A) includes a Schottky diode (26) and the collector-emitter path of an NPN transistor in series between the voltage source (Vcc) and the driver output (20), the gate terminal of the first controllable switch (A) being the base of the NPN transistor (24).

4. The bus driver circuit as claimed in claim 2 or 3, **characterized in that** the second controllable switch (C) includes a PMOS transistor (32) controlled by the comparator (D), the source-drain path of the PMOS transistor (32) being connected in series between the driver input (16) and the gate of the PMOS transistor (30), and that it further includes a Schottky diode (36), which switches the voltage from the driver output (20) through to the gate of the PMOS transistor (30) when the comparator (D) supplies the control signal.

## Revendications

1. Circuit d'étage d'attaque de bus comportant une entrée (16) de l'étage d'attaque pour la réception d'un signal de données et une sortie (20) de l'étage d'attaque pour l'application de la tension de sortie d'une source de tension (Vcc) à une ligne de bus (10) en fonction de la présence du signal de données au niveau de l'entrée (16) de l'étage d'attaque,
**caractérisé par**
a) un premier interrupteur commandable (A) situé entre la source de tension (Vcc) et la sortie (20) de l'étage d'attaque,
b) une branche (B) de circuit de commande, qui peut, lors de l'application du signal de données à l'entrée (16) de l'étage d'attaque, être placée dans un état actif, par le fait qu'elle produit un signal de commande qui place l'interrupteur commandable (A) dans l'état conducteur,
c) un second interrupteur commandable (C) situé entre la branche (B) du circuit de commande et l'entrée (16) de l'étage d'attaque, et
d) un comparateur (D) qui compare la tension sur la sortie (20) de l'étage d'attaque à une tension de référence (V_{ref}) et ensuite, lorsque la tension à la sortie (20) de l'étage d'attaque est supérieure à la tension de sortie (Vcc) de la source de tension, délivre un signal de commande qui bloque le second interrupteur commandable (C) et place la branche (B) du circuit de commande dans l'état inactif, par le fait qu'il bloque le premier commutateur commandable (A).

2. Circuit d'étage d'attaque de bus selon la revendication 1, **caractérisé en ce que** la branche (B) du circuit de commande contient un transistor PMOS (30) et une résistance (28) en série entre la source de tension et la sortie (20) de l'étage d'attaque, que la borne de grille du transistor PMOS (30) est reliée dans la branche (B) du circuit de commande à l'entrée (16) de l'étage d'attaque par l'intermédiaire d'une voie source-drain du transistor PMOS (32), qui fait partie du second interrupteur commandable (C) et que le point de liaison entre la borne de source du transistor PMOS (30) et la résistance (28) est relié à une borne de commande du premier interrupteur commandable (A).

3. Circuit d'étage d'attaque de bus selon la revendication 2, **caractérisé en ce que** le premier interrupteur commandable (A) contient, en série entre la source de tension (Vcc) et la sortie (20) de l'étage d'attaque, une diode Schottky (26) et la voie collecteur-émetteur d'un transistor NPN, la borne de commande du premier interrupteur commandable (A) constituant la base du transistor NPN (24).

4. Circuit d'étage d'attaque de bus selon la revendication 2 ou 3, **caractérisé en ce que** le second interrupteur commandable (C) contient un transistor PMOS (32) commandé par le comparateur (D) et dont la voie source-drain est disposée en série entre l'entrée (16) de l'étage d'attaque et la borne de grille du transistor PMOS (30), et qu'il contient en outre une diode Schottky (36), qui transmet la tension de la sortie (20) de l'étage d'attaque à la borne de grille du transistor PMOS (30), lorsque le comparateur (D) délivre le signal de commande.
